# EUROPEAN PATENT APPLICATION

(11) **EP 2 501 045 A1**
(43) Date of publication of application: **19.09.2012**
(21) Application number: 10829993.4
(22) Date of filing: 11.11.2010
(51) Int. Cl.: H03M 1/18, B60K 5/12, F16F 15/02

(54) **A/D CONVERSION DEVICE, DAMPING DEVICE, AND VEHICLE MOUNTED WITH THESE**

(30) Priority: 13.11.2009 JP 2009259685
(71) Applicant: Sinfonia Technology Co., Ltd., Tokyo 105-8564 (JP)
(72) Inventor: MATSUNO, Keisuke, Ise-shi Mie 516-8550 (JP); KATADA, Hidetoshi, Ise-shi Mie 516-8550 (JP); TOMIZAKI, Takeshi, Ise-shi Mie 516-8550 (JP); MORIYA, Hideaki, Ise-shi Mie 516-8550 (JP)
(74) Representative: TBK
(86) International application number: PCT/JP2010/070126
(87) International publication number: WO 2011/059034

(57) **Abstract**

An A/D conversion device has a first A/D conversion unit (73) configured to convert an analog vibration signal (sg1) input from a vibration detecting sensor (1) to detect the vibration into a digital value (digi1) and, a second A/D conversion unit (74) configured to input an analog vibration signal (sg2) corresponding to an amplified analog vibration signal (sg1), so as to convert the signal into a digital value (digi2); a determination unit (81) configured to determine whether or not an input saturation state, where an amplitude value of the analog vibration signal (sg2) exceeds an amplitude range convertible at the second A/D conversion unit (74), is occurring; and a selection unit (82) configured to output the digital value (digi1) converted by the first A/D conversion unit (73) when the determination unit (81) determines an input saturation state is occurring, and to output the digital value (digi2) converted by the second A/D conversion unit (74) when the determination unit (81) determines an input saturation state is not occurring.

## Description

### TECHNICAL FIELD

The present invention relates to an A/D conversion device that appropriately applies an analog-to-digital conversion to a signal from a vibration sensor, or a damping device to which the same is applied, and a vehicle mounted with these devices.

### BACKGROUND ART

Damping devices are conventionally known that offset vibration generated at a vibration generating source such as a vehicle engine, with offsetting vibration generated through an excitation means, at a location where the vibration should be damped. As such a conventional damping device, Patent Document 1 discloses a damping device including: a control unit configured to generate an excitation command signal so as to offset vibration that is transmitted from a vibration generating source to a location to be damped; an excitation means operated by the input of an excitation command signal generated at the control unit so as to generate the offsetting vibration at the location to be damped; and a vibration detecting sensor, such as an acceleration sensor, configured to detect, at the location to be damped, the vibration remaining as an offsetting error between the vibration generated at the vibration generating source and the offsetting vibration, wherein the control unit corrects the excitation command signal so as to reduce the size of vibration remaining as an offsetting error based on the vibration detected by the vibration detecting sensor.

The damping device converts, with an A/D conversion device, an analog vibration signal output from the vibration detecting sensor into a digital value, and controls to dampen it by using the digital value.

### PRIOR ART DOCUMENT

### PATENT DOCUMENT

Patent Document 1: Japanese Unexamined Patent Application Publication No. 2000-27931

### SUMMARY OF THE INVENTION

### PROBLEMS TO BE SOLVED BY THE INVENTION

The A/D conversion device installed on the above-described damping device is required to have high resolution for certainly detecting a change in minute vibrations near the zero level so as to determine whether or not vibrations are damped, and is also required to have a convertible amplitude range that is wide enough to respond to vibrations of various magnitudes.

In response to the both requirements, the use of an A/D conversion unit may be considered that combines a wide convertible amplitude range and high resolution. However, this A/D conversion unit is expensive and increases manufacturing costs, and thus is not preferable.

As one way of obtaining high resolution without an expensive A/ D conversion unit, a configuration may be considered in which an analog vibration signal amplified through an amplitude amplifier is input to an inexpensive and low resolution A/D conversion unit. However, in this configuration, the A/D convertible amplitude range becomes narrow while high resolution is obtained, causing input saturation state due to the input of large amplitude vibrations without allowing an accurate digital value conversion, which is troublesome.

The present invention has been achieved taking the aforementioned circumstances into consideration; and an object thereof is to provide an A/D conversion device that has high resolution and a wide convertible amplitude range without increasing manufacturing costs, and also to provide a damping device having improved damping properties, and also to provide a vehicle mounted with these devices.

### MEANS FOR SOLVING THE PROBLEM

In order to achieve this object, the present invention took the following measures.

Specifically, the A/D conversion device of the present invention is a device that is input with a signal from a vibration detecting sensor for detecting vibrations, and converts it into a digital value and then externally outputs the converted digital value, the device comprising: a first A/D conversion unit configured to convert an analog vibration signal that is input from the vibration detecting sensor, corresponding to a signal input, into a digital value; a second A/D conversion unit configured to convert the input amplified signal corresponding to an amplified analog vibration signal input to the first A/D conversion unit, into a digital value; a determination unit configured to determine whether or not an input saturation state, where the amplitude value of the amplified signal input to the second A/D conversion unit exceeds an amplitude range convertible at the second A/D conversion unit, is occurring; and a selection unit configured to output the digital value converted by the first A/D conversion unit when the determination unit determines that the input saturation state is occurring, and also output the digital value converted by the second A/D conversion unit when the determination unit determines that the input saturation state is not occurring.

In this configuration, when the input saturation state, where the amplitude value of the amplified signal input to the second A/ D conversion unit exceeds the amplitude range convertible at the second A/D conversion unit, is not occurring; that is, when the vibration to be detected is in the minute range, it becomes possible to digitalize an amplified signal and digitalize, with high resolution, the amplitude value of the vibration in a minute range. Additionally, at the input saturation state, that is, when the vibration to be detected exceeds the minute range, it becomes possible to digitalize an analog vibration signal, and to appropriately digitalize the amplitude value of the vibration in the minute range, which requires higher resolution, and by specifying, with ordinary resolution, the amplitude value of a vibration in a wide range outside of the minute range, and then accurately capturing the amplitude value of the vibration in the wide range.

In order to effectively determine either an input saturation state or not, it is particularly preferable that the determination unit determine that the input saturation state is occurring when the digital value obtained either at the first A/D conversion unit or the second A/D conversion unit exceeds a predetermined threshold, and determine that the input saturation state is not occurring when the digital value does not exceed the predetermined threshold.

In order to prevent data omission by maintaining the continuity of digital values which show the amplitude values of vibrations, it is desirable that the digital value obtained at the first A/D conversion unit and externally output, and the digital value obtained at the second A/D conversion unit and externally output, have a matching change rate and zero point with respect to a fluctuation in amplitude values of the signals input from the vibration detecting sensor.

It is preferable that the A/ D conversion device of the present invention be applied to a damping device which is required to detect minute vibrations near the zero level.

This damping device can be particularly preferably used, mounted in a vehicle, when damping the vibration from its engine.

### EFFECT OF THE INVENTION

The present invention, as described above, determines whether or not the input saturation state, where the amplitude value of an amplified signal input to the second A/D conversion unit exceeds the amplitude range convertible at the second A/D conversion unit, is occurring, thus outputting a digital value obtained by converting an analog vibration signal when the input saturation state is determined, and outputting a digital value obtained by converting an amplified signal corresponding to an amplified analog vibration signal when the input saturation state is not determined. Accordingly, high resolution will be provided when the input saturation state is not occurring; the A/D conversion of a wide convertible amplitude range will be achieved at the input saturation state; furthermore, damping properties will improve.

### BRIEF DESCRIPTION OF THE DRAWINGS

[Fig. 1] Fig. 1 is a schematic configuration diagram illustrating a damping device applied to a vehicle according to an embodiment of the present invention.
[Fig. 2] Fig. 2 is a schematic configuration diagram illustrating an excitation means equipped with a linear actuator configuring the damping device.
[Fig. 3] Fig. 3 is a block diagram illustrating the configuration of a control unit and an A/D conversion device of the damping device.
[Fig. 4] Fig. 4 is a block diagram illustrating the configuration of the A/D conversion device and its operation when vibration amplitude values are in a minute range.
[Fig. 5] Fig. 5 is a block diagram illustrating the configuration of the A/D conversion device and its operation when vibration amplitude values are not in a minute range.
[Fig. 6] Fig. 6 is a block diagram illustrating the configuration of an A/D conversion device according to another embodiment of the present invention.

### BEST MODES FOR CARRYING OUT THE INVENTION

An embodiment of the present invention will be explained below by referring to the figures.

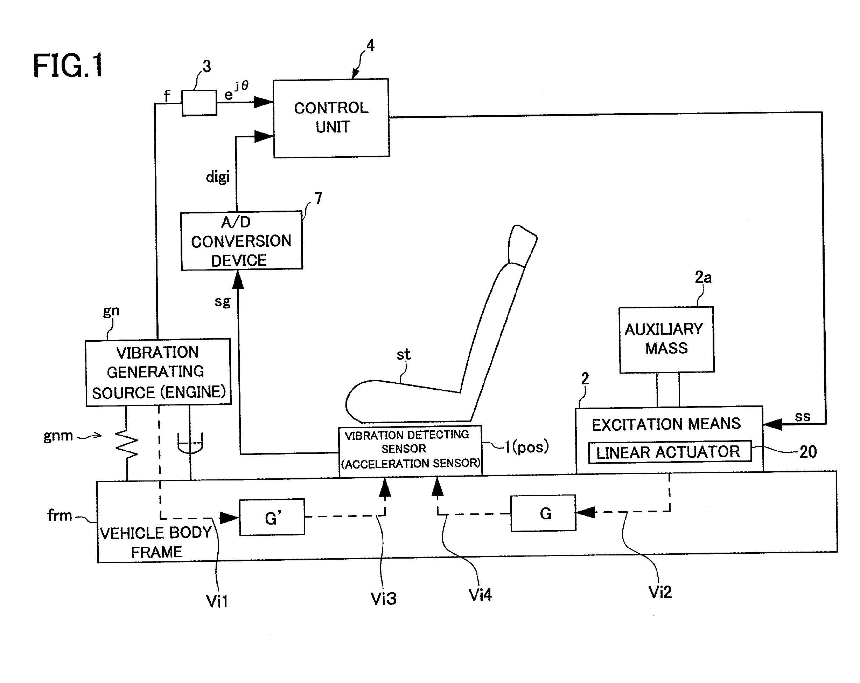

A damping device of the embodiment, as shown in Fig. 1, is mounted on a vehicle such as an automobile. The device includes: a vibration detecting sensor 1, such as an acceleration sensor, arranged at a location pos, such as a seat st, where the vibration should be damped; an excitation means 2 using a linear actuator 20 so as to generate an offsetting vibration Vi4 at the location pos to be damped by vibrating an auxiliary mass 2a having a predetermined mass; a reference wave generating means 3 configured to generate a reference wave e^{jθ} from a fundamental frequency f taken from the ignition pulse of an engine that is a vibration generating source gn; an A/D conversion device 7 configured to convert an analog vibration signal sg from the vibration detecting sensor 1 into a digital value digi; and a control unit 4 configured to control so that the excitation means 2 generates the offsetting vibration Vi4 at the location pos to be damped by inputting the digital value digi from the A/ D conversion device 7 and the reference wave e^{jθ}. The device offsets the vibration Vi3 generated at the vibration generating source gn, such as an engine, mounted on a vehicle body frame frm through a mounter gnm, with the offsetting vibration Vi4 generated through the excitation means 2 at the location pos to be damped, thereby reducing vibration at the location pos to be damped.

The vibration detecting sensor 1 detects main vibration in the same direction as that of the main vibration of an engine by using an acceleration sensor or the like, and outputs an analog vibration signal sg that shows the amplitude value of vibration in voltage.

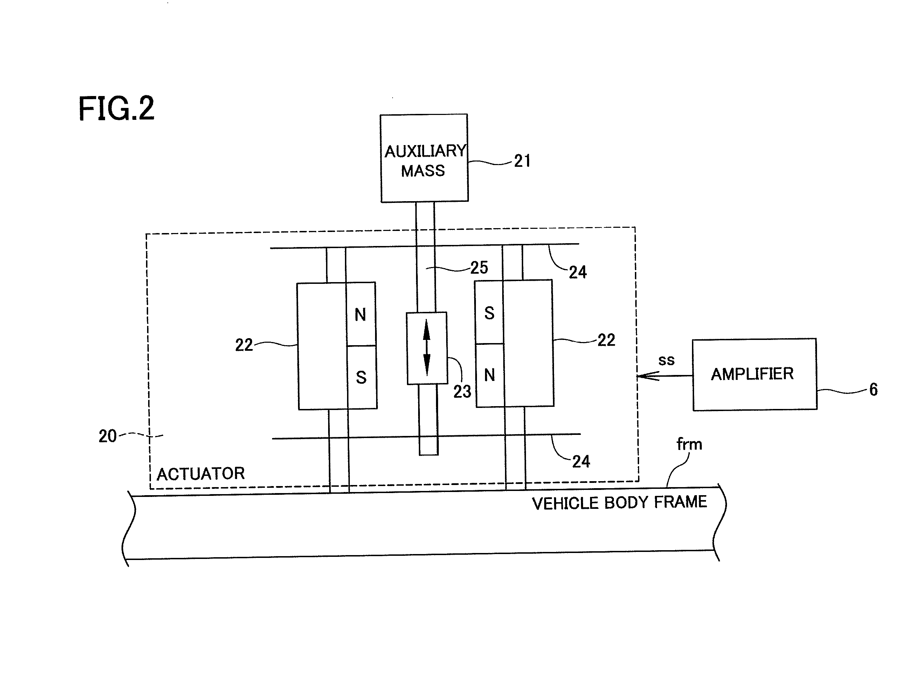

The linear actuator 20, as illustrated in Fig. 2, is of reciprocating type in which a stator 22 having a permanent magnet is fixed to the vehicle body frame frm so as to allow a mover 23 to move in a reciprocal movement (vertical in Fig. 2) direction, the same as the direction of vibration to be controlled. Here, the stator 22 is fixed to the vehicle body frame frm so as to match the direction of the vibration of the vehicle body frame frm needing to be controlled, to the reciprocal movement (thrust) direction of the mover 23. The mover 23 is attached to a shaft 25 together with an auxiliary mass 21. The shaft 25 is supported by the stator 22 through a flat spring 24, allowing the mover 23 and the auxiliary mass 21 to shift in the thrust direction. The linear actuator 20 and the auxiliary mass 21 constitute a dynamic vibration absorber.

In case of applying an alternating current (sine wave current, rectangular wave current) to a coil (not shown in the figure) of the linear actuator 20, a magnetic flux is led from the south pole to the north pole by the permanent magnet when an electric current flows through the coil in a predetermined direction, and a magnetic flux loop is thereby formed. Accordingly, the mover 23 shifts in the direction against the gravity (upward direction). Additionally, the mover 23 shifts in the gravity direction (downward direction) when the electric current is applied to the coil in the direction reverse to the predetermined direction. The mover 23 repeats the above-described motions by alternating the direction of an electric current flowing to the coil with the application of an alternating current, and reciprocates, with respect to the stator 22, in the direction of the shaft 25. Thus, the auxiliary mass 21 adjoined to the shaft 25 vibrates in a vertical direction. Since more specific structure and operation of the linear actuator 20 are conventionally known, the detailed explanation thereof is omitted herein. The mover 23 has its range of action regulated by a stopper not shown in the figure. The dynamic vibration absorber, including the linear actuator 20 and the auxiliary mass 21, controls damping force by controlling the acceleration of the auxiliary mass 21 based on a current control signal ss output from an amplifier 6, thereby offsetting the vibration generated at the vehicle body frame frm and thus reducing vibration.

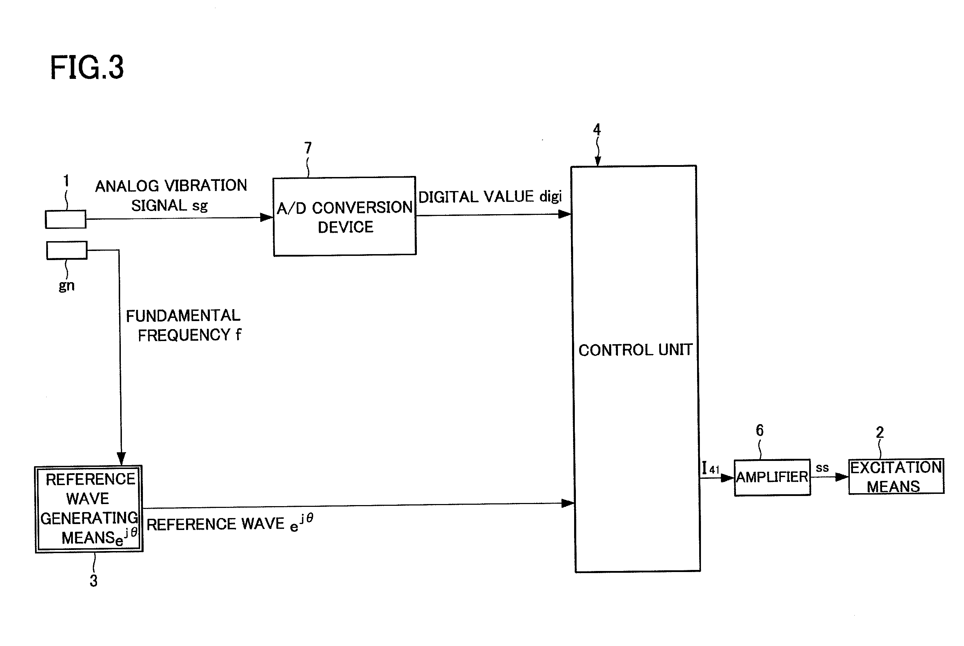

The reference wave generating means 3, as illustrated in Fig. 3, generates, from a fundamental frequency f [Hz], a reference sine wave (sinθ) and a reference cosine wave (cosθ) as reference waves e^{jθ} in a fundamental degree. The reference sine wave (sinθ) and reference cosine wave (cosθ) to be generated may or may not be synchronized to any synchronous signal. θ = ωt = 2πft.

The A/D conversion device 7 converts the analog vibration signal sg input from the vibration detecting sensor 1 into a digital value digi as a digital signal. The detail thereof will be described below.

The control unit 4 controls vibrations by adaptive control, calculates an adaptive filter coefficient (Re, Im) from the digital value digi converted by the A/D conversion device 7 and the reference wave e^{jθ}, then generates an excitation command signal I₄₁ based on the adaptive filter coefficient (Re, Im), and inputs a current control signal ss to the linear actuator 20 through the amplifier 6 described below based on the command signal I₄₁, thereby generating, at the location pos to be damped, the offsetting vibration Vi4 having a phase reverse that of the vibration from the vibration generating source gn, through the excitation means 2. As the adaptive filter coefficient (Re, Im) is repeatedly calculated, the amplitude value and phase of the offsetting vibration Vi4 converge with those of the vibration Vi3 that must be damped. The vibration is offset as the value and phase converge; however, as basic frequencies f and the amplitude values and phases of the vibration Vi3 change constantly, the control unit 4 performs control by constantly tracking the changes.

For such damping control, the A/D conversion device 7 is required to have high resolution for appropriately converting the change of minute vibration near the zero level into a digital value so as to determine a damped or non-damped state, and is also required to have a wide amplitude range that is digitally convertible so as to respond to vibrations of various magnitudes.

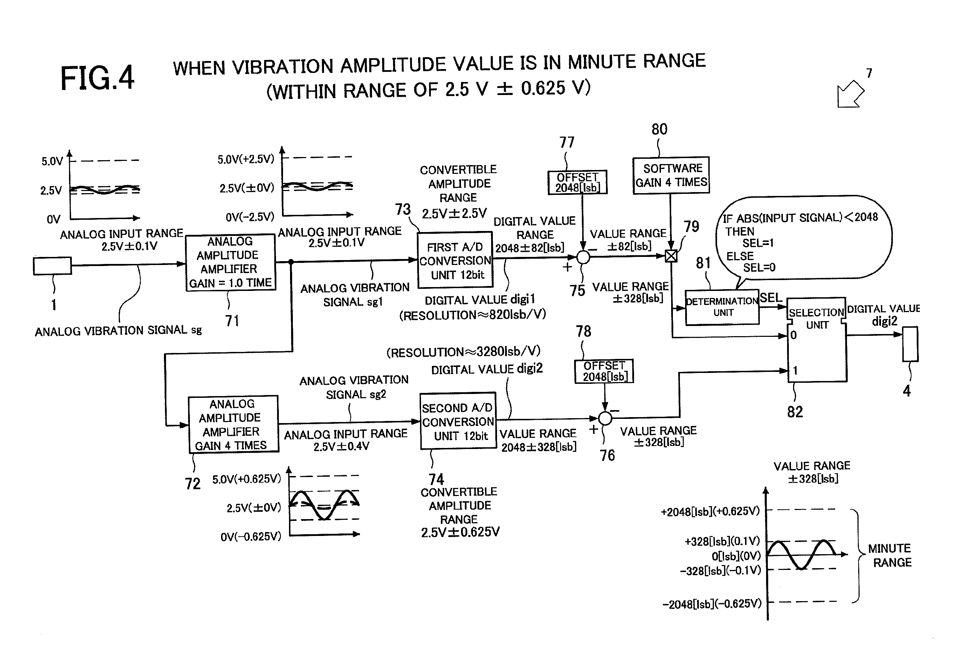

Thus, in the embodiment, as illustrated in Fig. 4, the A/D conversion device 7 is configured by using an inexpensive generic A/D conversion unit having a digital processing unit such as a CPU and a plurality of A/D conversion units. The conversion device 7 includes analog amplitude amplifiers 71 and 72, a first A/D conversion unit 73, a second A/D conversion unit 74, a determination unit 81, and a selection unit 82.

The analog amplitude amplifier 71 is input with an analog vibration signal sg from the vibration detecting sensor 1 where the amplitude value of vibration is expressed in volts, and then outputs an analog vibration signal sg1 after the amplitude (voltage) of the analog vibration signal sg is amplified one time. The analog amplitude amplifier 72 is input with the analog vibration signal sg1 output from the analog amplitude amplifier 71, and then outputs an analog vibration signal sg2 as an amplified signal after the amplitude (voltage) of the analog vibration signal sg1 is amplified four times. The voltage fluctuation range of the analog vibration signal sg is 2.5 V ± 2.0 V.

The first A/D conversion unit 73 and the second A/D conversion unit 74 have the input voltage range of 2.5 V ± 2.5 V and the resolution of 12 bit = 4096 [lsb] (lsb as a quantization unit), and both have the same properties. The first A/D conversion unit 73 is input with the analog vibration signal sg1 corresponding to the analog vibration signal sg input from the vibration detecting sensor 1, and converts the signal into a digital value digi1 and then outputs it. In this case, the analog vibration signal sg1 input to the first A/D conversion unit 73 is a signal having the amplification factor of 1 with respect to the analog vibration signal sg, and the voltage range that can be input to the first A/D conversion unit 73 is 2.5 V ± 2.5 V. Thus, the convertible amplitude range (voltage range) is 2.5 V ± 2.5 V with the analog vibration signal sg as a reference; effective resolution is about 820 [lsb]/v; and the minimum analog quantity to be quantized is about 0.0012195 V/[lsb].

The second A/D conversion unit 74 is input with the analog vibration signal sg2 as an amplified signal corresponding to an amplified analog vibration signal sg1 input to the first A/D conversion unit 73, and converts the signal into a digital value digi2 and then outputs it. In this case, the analog vibration signal sg2 input to the second A/D conversion unit 74 is a signal that is the analog vibration signal sg amplified at the amplification factor of 4, and the input voltage range is 2.5 V ± 2.5 V. Therefore, the convertible amplitude range (voltage range) is 2.5 V ± 0.625 V with the analog vibration signal sg as a reference; effective resolution is about 3280 [lsb]/v; and the minimum analog quantity to be quantized is about 0.0003048 V/[lsb]. While the second A/D conversion unit 74 has the effective resolution four times as great as that of the first A/D conversion unit 73, its convertible amplitude range decreases to 1/4 times.

An offset value 2048 [lsb] is subtracted from the digital value digi1 and the digital value digi2 output from the first A/D conversion unit 73 and the second A/D conversion unit 74, at each one of adders 75 and 76, providing zero reference points (zero points) and then inputting the digital values individually to the selection unit 82. The digital value digi1 output from the adder 75 is amplified four times by a software gain at a multiplier 79 so as to match a change rate with respect to a fluctuation in amplitude values of the analog vibration signal sg, with that of the digital value digi2, and is then input to the selection unit 82.

The determination unit 81 determines whether or not the input saturation state, where the amplitude value of the analog vibration signal sg2 as an amplified signal input to the second A/D conversion unit 74 exceeds the amplitude range convertible at the second A/D conversion unit 74 (2.5 V ± 0.625 V), is occurring. Specifically, the determination unit 81 detects the digital value digi1 input from the multiplier 79 to the selection unit 82; determines the input saturation state when the absolute value of the digital value digi1 exceeds the predetermined threshold 2048 [lsb], and also determines that the input saturation state is not occurring when the absolute value of the digital value digi1 does not exceed the predetermined threshold 2048 [lsb]; and inputs a determination signal SEL to a selection unit 82 as a determination result.

When the input saturation state is determined by the determination unit 81, the selection unit 82 inputs the digital value digi1 converted by the first A/D conversion unit 73 to the external control unit 4. Additionally, when the input saturation state is not determined by the determination unit 81, the selection unit 82 inputs the digital value digi2 converted by the second A/D conversion unit 74 to the external control unit 4.

Fig. 4 is referred to in order to explain the operation of the configuration described above when the voltage of the analog vibration signal sg is 2.5 V ± 0.1 V: in other words, when the vibration amplitude value to be detected is in a minute range (within the range of 2.5 V ± 0.625 V).

First, the vibration detecting sensor 1 outputs the analog vibration signal sg which fluctuates within the range of 2.5 V ± 0.1 V, and the analog vibration signal sg1 having the same fluctuation is input to the first A/D conversion unit 73 through the analog amplitude amplifier 71, converting the signal into the digital value digi1 having the range of 2048 ± 82 [lsb]. Subsequently, the offset value 2048 [lsb] is subtracted from the digital value digi1 so as to set the reference point of 2.5 V to 0 V at the adder 75, so that the range of the digital value digi1 is ± 82 [lsb]. Finally, the digital value digi1 is amplified four times by a software gain at the multiplier 79, so that the range is ± 328 [lsb]. The digital value is then input to the selection unit 82.

On the other hand, the analog vibration signal sg is amplified through the analog amplitude amplifiers 71 and 72, and becomes the analog vibration signal sg2 which fluctuates within the range of 2.5 V ± 0.4 V. This analog vibration signal sg2 is input to the second A/D conversion unit 74, and is converted into the digital value digi2 having the range of 2048 ± 328 [lsb]. Subsequently, the offset value 2048 [lsb] is subtracted from the digital value digi2 so as to set the reference point of 2.5 V to 0 V at the adder 76, so that the range of the digital value digi2 would be ±328 [lsb]. The digital value is then input to the selection unit 82.

In this case, the determination unit 81 determines that the input saturation state is not occurring since the range of the digital value digi1 is ± 328 [lsb]. As a result, the selection unit 82 outputs the digital value digi2 digitalized, with high resolution, at the second A/D conversion unit 74, to the external control unit 4. As shown in Fig. 4, the range of ± 0.625 V as the minute range is expressed as 4096 [lsb], enabling reproduction of vibration that is digitalized with high resolution.

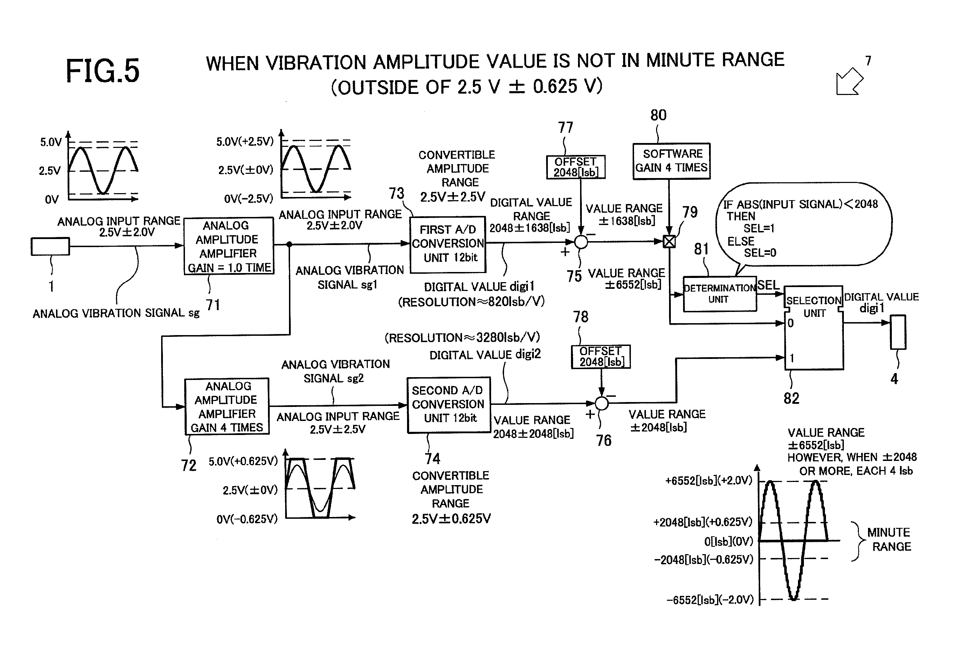

Similarly, Fig. 5 is referred to in order to explain the operation thereof when the voltage of the analog vibration signal sg is 2.5 V ± 2.0 V, in other words, when the vibration amplitude value to be detected is not in the minute range (outside the range of 2.5 V ± 0.625 V).

First, the vibration detecting sensor 1 outputs the analog vibration signal sg that fluctuates within the range of 2.5 V ± 2.0 V, and the analog vibration signal sg1 having identical fluctuations is input to the first A/D conversion unit 73 through the analog amplitude amplifier 71, converting the signal into the digital value digi1 having the range of 2048 ± 1638 [lsb]. Subsequently, the offset value 2048 [lsb] is subtracted from the digital value digi1 so as to make the reference point of 2.5 V to 0 V at the adder 75, so that the range of the digital value digi1 would be ± 1638 [lsb]. Finally, the digital value digi1 is amplified four times by a software gain at the multiplier 79, providing the range of ± 6552 [lsb]. The digital value is input to the selection unit 82.

On the other hand, the analog vibration signal sg is amplified through the analog amplitude amplifiers 71 and 72, and becomes the analog vibration signal sg2 that varies within the range of 2.5 V ± 8.0 V. This analog vibration signal sg2 is input to the second A/D conversion unit 74, and is converted into the digital value digi2 having the range of 2048 ± 2048 [lsb], providing the input saturation state. Subsequently, the offset value 2048 [lsb] is subtracted from the digital value digi2 so as to make the reference point of 2.5 V to the 0 V at the adder 76, thus providing the digital value digi2 at the range of ± 2048 [lsb]. This digital value is input to the selection unit 82.

In this case, the determination unit 81 determines the input saturation state since the range of the digital value digi1 is ± 6552 [lsb]. As a result, the selection unit 82 inputs the digital value digi1 that is digitalized at the first A/D conversion unit 73, to the control unit 4 that is a utilization unit. As shown in Fig. 5, the range of ± 0.625 V as the minute range is expressed as 4096 [lsb], enabling reproduction of vibration that is digitalized with high resolution of about 3280 [lsb]/V. Additionally, the resolution becomes rougher than the resolution in the minute range, at about 820 [lsb]/V in the wide range that is the outside of the minute range of ± 0.625 V. However, the input saturation state exceeding the amplitude range for digitalization is prevented, thus allowing the signal to convert into an accurate digital value.

As described above, the A/D conversion device of the embodiment inputs the analog vibration signal sg from the vibration detecting sensor 1 configured to detect vibrations, and converts it into digital values digi (digi1, digi2) and then outputs the converted digital values digi (digi1, digi2) to the external control unit 4. The conversion device has the first A/D conversion unit 73 configured to input the analog vibration signal sg1 corresponding to the analog vibration signal sg input from the vibration detecting sensor 1 and convert it into the digital value digi1; the second A/D conversion unit 74 configured to input the analog vibration signal sg2 as an amplified signal corresponding to an amplified analog vibration signal sg1 input to the first A/D conversion unit 73, and convert it into the digital value digi2; the determination unit 81 configured to determine whether or not the input saturation state, where the amplitude value of the analog vibration signal sg2 as an amplified signal input to the second A/D conversion unit 74 exceeds the amplitude range convertible at the second A/D conversion unit 74, is occurring; and the selection unit 82 configured to output only the digital value digi1 converted by the first A/D conversion unit 73 when the determination unit 81 determines the input saturation state, and output only the digital value digi2 converted by the second A/D conversion unit 74 when the determination unit 81 determines that the input saturation state is not occurring.

In this configuration, when not at the input saturation state where the amplitude value of the analog vibration signal sg2 as an amplified signal input to the second A/D conversion unit 74 exceeds the amplitude range convertible at the second A/D conversion unit 74; that is, when the vibration to be detected is in the minute range, the analog vibration signal sg2 as an amplified signal is digitalized, and the amplitude value of the vibration in the minute range is digitalized with high resolution, thus externally outputting only the digitalized value digi2. Additionally, at the input saturation state, that is, when the vibration to be detected exceeds the minute range, the analog vibration signal sg1 is digitalized; the amplitude value of the vibration in the wide range outside of the minute range is digitalized with ordinary resolution, thus externally outputting only the digital value digi1. The amplitude value of the vibration in the wide range can be accurately detected, and at the same time, the amplitude value of vibration in the minute range, which requires high resolution, can be appropriately digitalized.

Moreover, in the embodiment, the determination unit 81 determines the input saturation state when the digital value digi1 obtained by the first A/D conversion unit 73 exceeds a predetermined threshold, and determines that the input saturation state is not occurring when the digital value digi1 does not exceed the predetermined threshold. Therefore, it becomes possible to effectively determine whether or not the input saturation state is occurring based on where the predetermined threshold is set.

Furthermore, in the embodiment, the digital value digi1 provided by the first A/D conversion unit 73 and output to the external control unit 4, and the digital value digi2 provided by the second A/D conversion unit and output to the external control unit 4, have a matching change rate and zero point with respect to a fluctuation in amplitude values of the analog vibration signals sg input from the vibration detecting sensor 1. Thus, even if the digital values digi output to the external control unit 4 switch, continuity of the digital values digi showing the amplitude value of vibrations is maintained, preventing data omission.

Therefore, when such an A/D conversion device is applied to a damping device, damping performances improve. Furthermore, by mounting the damping device having the A/D conversion device on a vehicle, the reliability and endurance of the vehicle's damping functions will effectively improve, providing superior cruising function.

Although an embodiment of the present invention was explained above, the specific configuration of each unit is not limited only to those in the embodiment described above.

For instance, although the analog vibration signal sg1 is input to the first A/D conversion unit 73 through the analog amplitude amplifier 71 and the analog vibration signal sg2 is input to the second A/D conversion unit 74 through the analog amplitude amplifier 72 in the embodiment, any amplifying circuit may be used as long as the signal input to the second A/D conversion unit is equivalent to an amplified signal input to the first A/D conversion unit in the present invention. For example, it is possible to use a standard configuration which amplifies signals at an analog circuit. Examples include a configuration in which the signal input to the first A/D conversion unit 73 is inverted and amplified to provide a signal An2 and the signal An2 is further inverted and amplified to provide An3, and a signal obtained by a difference between An2 and An3 is input to the second A/D conversion unit.

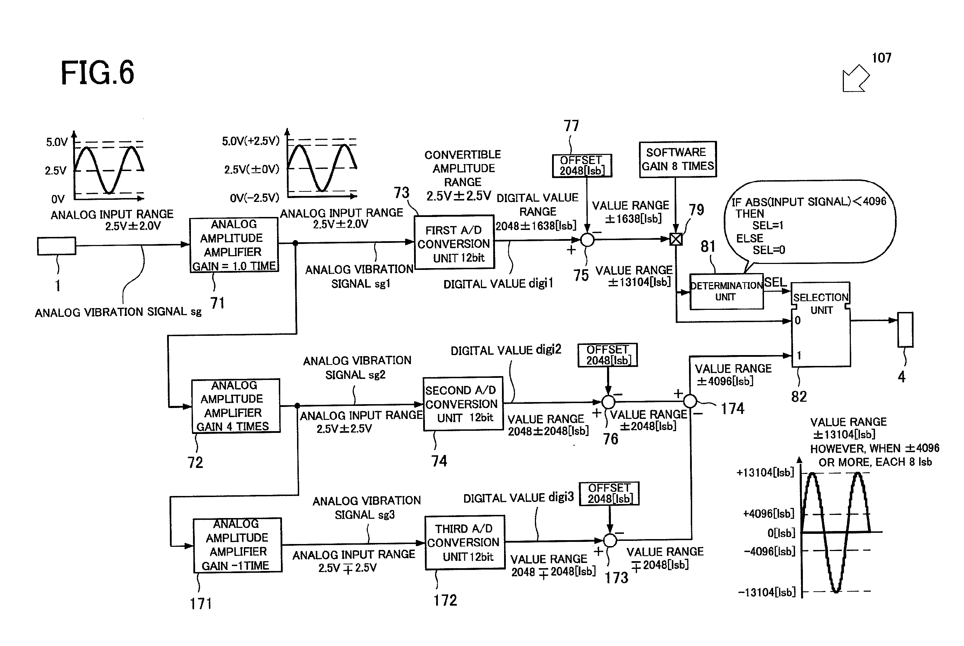

In order to provide higher resolution, as shown in Fig. 6, the software gain for multiplying at the multiplier 79 of the embodiment is increased eight times. The A/D conversion device 107 may further include an analog amplitude amplifier 171, a third A/D conversion unit 172, and adders 173 and 174. The analog amplitude amplifier 171 is input with the analog vibration signal sg2 output from the analog amplitude amplifier 72, and outputs the analog vibration signal sg3 that is provided by inverting the amplitude (voltage) of the analog vibration signal sg2. The third A/D conversion unit 172 is input with the analog vibration signal sg3, and converts the signal into the digital value digi3 and then outputs it. The offset value 2048 [lsb] is subtracted from the digital value digi3 output from the A/D conversion unit 172, at the adder 173, providing a zero reference point (zero point). The digital value digi3 and the digital value digi2 output from the adder 76 are added at the adder 174 and then input to the selection unit 82.

Furthermore, although the determination unit 81 determines whether or not the input saturation state is occurring by monitoring the digital value digi1 in the embodiment, the configuration may be such that the digital value digi2 or others may be monitored instead.

Additionally, the invention may be applied to mobile apparatuses and devices, other than a vehicle, in which the generation of vibration is a problem, and may be modified within the scope of the present invention.

### INDUSTRIAL APPLICABILITY

The present invention described in detail as above determines whether or not the input saturation state, where the amplitude value of the amplified signal input to a second A/D conversion unit exceeds the amplitude range convertible at the second A/D conversion unit, is occurring. When the input saturation state is determined, a digital value obtained by converting an analog vibration signal is output. When the input saturation state is not determined, a digital value obtained by converting an amplified signal corresponding to an amplified analog vibration signal is output. Thus, an A/D conversion device will be provided inexpensively that has high resolution when not at the input saturation state and has a wide convertible amplitude range at the input saturation state. Furthermore, this A/D conversion device can be applied to a damping device and other signal processors.

## Claims

1. An A/D conversion device for converting a signal input from a vibration detecting sensor that detects vibration into a digital value and then externally outputting the converted digital value; the A/D conversion device comprising:
a first A/D conversion unit configured to convert an input analog vibration signal corresponding to a signal input from the vibration detecting sensor, into a digital value;
a second A/D conversion unit configured to convert an input amplified signal corresponding to an amplified analog vibration signal input to the first A/D conversion unit, into a digital value;
a determination unit configured to determine whether or not an input saturation state, where an amplitude value of an amplified signal input to the second A/D conversion unit exceeds an amplitude range convertible at the second A/D conversion unit, is occurring; and
a selection unit configured to output a digital value converted by the first A/D conversion unit when the determination unit determines that an input saturation state is occurring, and output a digital value converted by the second A/D conversion unit when the determination unit determines that an input saturation state is not occurring.

2. The A/D conversion device according to claim 1, wherein the determination unit determines that an input saturation state is occurring when a digital value obtained either at the first A/D conversion unit or the second A/D conversion unit exceeds a predetermined threshold, and determines that an input saturation state is not occurring when the digital value does not exceed the predetermined threshold.

3. The A/D conversion device according to claim 2, wherein a digital value obtained at the first A/D conversion unit and externally output, and a digital value obtained at the second A/D conversion unit and externally output, have a matching change rate and zero point with respect to fluctuation in amplitude values of signals input from the vibration detecting sensor.

4. A damping device comprising the A/D conversion device according to any one of claims 1 to 3.

5. A vehicle comprising the damping device according to claim 4.
